# FASCICULE DE BREVET EUROPEEN

(11) **EP 3 477 644 B1**
(45) Date de publication et mention de la délivrance du brevet: **22.12.2021**
(21) Numéro de dépôt: 18202885.2
(22) Date de dépôt: 26.10.2018
(51) Int. Cl.: G11C 11/56, G11C 13/00, H01L 45/00, H01L 27/24

(54) **POINT MÉMOIRE À MATÉRIAU À CHANGEMENT DE PHASE**
SPEICHERPUNKT AUS EINEM MATERIAL MIT PHASENÄNDERUNG
MEMORY POINT WITH PHASE-CHANGE MATERIAL

(30) Priorité: 27.10.2017 FR 1760166
(43) Date de publication de la demande: 01.05.2019
(73) Titulaire: STMicroelectronics (Crolles 2) SAS, 38920 Crolles (FR)
(72) Inventeur: MORIN, Pierre, 38000 GRENOBLE (FR); DUTARTRE, Didier, 38240 MEYLAN (FR)
(74) Mandataire: Cabinet Beaumont

(56) Documents cités:
- US-A1- 2003 052 320
- US-A1- 2006 157 679
- US-A1- 2010 127 232
- US-A1- 2014 117 302
- ASHVINI GYANATHAN ET AL: "Multi-Level Phase Change Memory Cells with SiN or Ta$_{2}$O$_{5}$ Barrier Layers", JAPANESE JOURNAL OF APPLIED PHYSICS, vol. 51, no. 2, 1 February 2012 (2012-02-01), page 02BD08, XP055653778, JP ISSN: 0021-4922, DOI: 10.1143/JJAP.51.02BD08
- SEUNGJAE JUNG ET AL: "Thermally-assisted Ti/Pr 0.7 Ca 0.3 MnO 3 ReRAM with excellent switching speed and retention characteristics", ELECTRON DEVICES MEETING (IEDM), 2011 IEEE INTERNATIONAL, IEEE, 5 December 2011 (2011-12-05), pages 3.6.1-3.6.4, XP032095875, DOI: 10.1109/IEDM.2011.6131483 ISBN: 978-1-4577-0506-9
- JIMÉNEZ-MOLINOS F ET AL: "Direct and trap-assisted elastic tunneling through ultrathin gate oxides", JOURNAL OF APPLIED PHYSICS, AMERICAN INSTITUTE OF PHYSICS, US, vol. 91, no. 8, 15 April 2002 (2002-04-15) , pages 5116-5124, XP012056234, ISSN: 0021-8979, DOI: 10.1063/1.1461062
- Kim Breitfelder: "The Authoritative Dictionary of IEEE Standards Terms", IEEE Standards Terms, 1 January 2000 (2000-01-01), XP055653994, Retrieved from the Internet: URL:https://ieeexplore.ieee.org/document/4 116787 [retrieved on 2019-12-18]

## Description

### Domaine

La présente demande concerne les puces électroniques, et plus particulièrement un point mémoire non volatile à matériau à changement de phase.

### Exposé de l'art antérieur

Dans un point mémoire à matériau à changement de phase, le matériau à changement de phase est par exemple un chalcogénure cristallin. Pour programmer un tel point mémoire, on chauffe le chalcogénure pour en faire fondre une partie. Après arrêt du chauffage, la partie fondue se refroidit suffisamment vite pour devenir amorphe. L'effacement du point mémoire est obtenu en chauffant le chalcogénure sans le faire fondre, afin que la partie amorphe recristallise. La lecture de l'état du point mémoire, programmé ou effacé, utilise la différence entre la conductivité électrique du chalcogénure amorphe et celle du chalcogénure cristallin.

Les points mémoire à changement de phase connus présentent divers inconvénients tels qu'un courant élevé pour la programmation, et divers problèmes de compacité. Ces problèmes sont cruciaux par exemple pour une puce électronique comprenant plusieurs millions, voire plusieurs milliards, de tels points mémoire. US 2010/127232 A1 décrit un mode de réalisation pour les cellules de mémoire à changement de phase(PCM). US 2006/157679 A1 et US 2003/052320 A1 décrivent d'autres modes de réalisation pour les cellules de mémoire à changement de phase(PCM). US 2014/117302 A1 décrit un mode de réalisation pour les cellules de mémoire à changement de phase(PCM) optimisées par une barrière thermique.

### Résumé

Un mode de réalisation prévoit de pallier tout ou partie des inconvénients ci-dessus.

Ainsi, un mode de réalisation prévoit un point mémoire à matériau à changement de phase, comprenant, sur un via de liaison avec un transistor, un élément de chauffage du matériau à changement de phase, et, entre le via et l'élément de chauffage, plusieurs premières couches en un matériau électriquement isolant ou de résistivité électrique supérieure à 2,5.10-5 Q.m, et des deuxièmes couches électriquement conductrices intercalées entre les premières couches, les interfaces entre les premières couches et les deuxièmes couches formant des barrières thermiques, les premières couches étant suffisamment minces pour pouvoir être traversées par un courant électrique par un effet de type effet tunnel.

Ainsi, un mode de réalisation prévoit un procédé de réalisation d'un point mémoire selon l'une quelconque des revendications 1 à 5, comprenant : a) former le via de liaison (108') ; b) former sur le via l'élément de chauffage (116) du matériau à changement de phase (118) ; et c) entre les étapes a) et b), former les premières couches et les deuxièmes couches.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un exemple n'entrant pas dans le cadre de l'invention revendiquée et est une vue schématique en coupe d'un point mémoire à matériau à changement de phase ;
la figure 2 est un exemple n'entrant pas dans le cadre de l'invention revendiquée et est une vue en coupe, partielle et schématique, d'un mode de réalisation d'un point mémoire à matériau à changement de phase ;
les figures 3A à 3D sont des exemples n'entrant pas dans le cadre de l'invention revendiquée et sont des vues en coupe, partielles et schématiques, illustrant des étapes d'un mode de réalisation d'un procédé de fabrication d'un point mémoire à matériau à changement de phase ;
les figures 4A et 4B sont des exemples n'entrant pas dans le cadre de l'invention revendiquée et sont des vues en coupe, partielles et schématiques, illustrant des étapes d'une variante du procédé des figures 3A à 3D ;
les figures 5A et 5B sont des exemples n'entrant pas dans le cadre de l'invention revendiquée et sont des vues en coupe, partielles et schématiques, illustrant des étapes d'un autre mode de réalisation d'un procédé de fabrication d'un point mémoire à matériau à changement de phase ; et
les figures 6A à 6D sont des modes de réalisation de l'invention et sont des vues en coupe, partielles et schématiques, illustrant des étapes d'un autre mode de réalisation d'un procédé de fabrication d'un point mémoire à matériau à changement de phase.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position absolue, tels que les termes "haut", "bas", etc., ou relative, tels que les termes "dessus", "dessous", "supérieur", "inférieur", etc., ou à des qualificatifs d'orientation, tels que les termes "horizontal", "vertical", etc., il est fait référence à l'orientation de l'élément concerné dans les figures, étant entendu que, dans la pratique, les dispositifs décrits peuvent être orientés différemment.

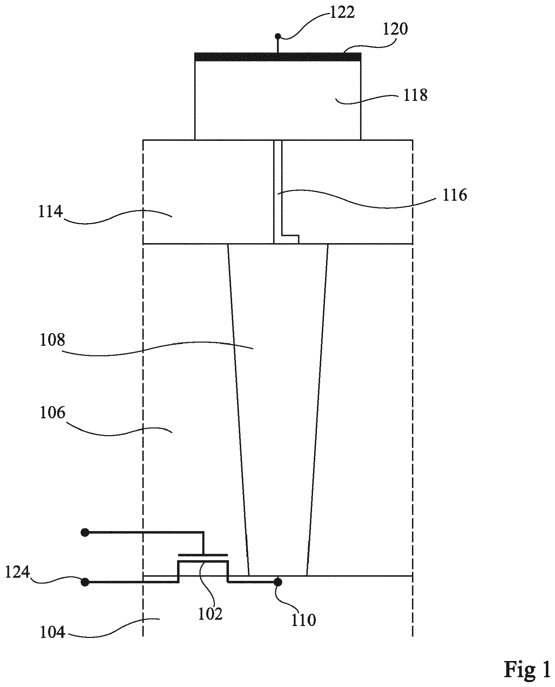

La figure 1 est un exemple n'entrant pas dans le cadre de l'invention revendiquée et est une vue schématique en coupe d'un point mémoire à matériau à changement de phase.

Un transistor 102, par exemple de type MOS, mais pouvant aussi être de type bipolaire, est formé dans et sur un support semiconducteur 104. Ce transistor est représenté de façon symbolique. Le transistor 102 et le support 104 sont recouverts d'une couche 106 électriquement isolante, par exemple en oxyde de silicium. Un via électriquement conducteur 108, par exemple en tungstène, traverse la couche 106 de part en part et a son extrémité inférieure en contact avec le drain 110 du transistor 102. La couche 106 et le via 108 sont recouverts d'une couche électriquement isolante 114, par exemple en nitrure de silicium, traversée de part en part par un élément résistif 116. L'élément résistif 116 est disposé sur le via 108 et est en contact avec le via 108. L'élément résistif est par exemple en nitrure de silicium et de titane TiSiN, et est typiquement en forme de mur d'épaisseur par exemple comprise entre 2 et 10 nm, de largeur par exemple supérieure à 15 nm et de hauteur par exemple comprise entre 30 et 150 nm. L'élément résistif 116 et la couche isolante 114 sont surmontés d'un matériau à changement de phase 118 recouvert d'une prise de contact 120 reliée à un noeud 122. Le matériau à changement de phase 118, l'élément résistif 116 et le transistor 102 se trouvent ainsi reliés électriquement en série entre le noeud 122 et la source 124 du transistor 102.

Pour programmer ou effacer le point mémoire, on sélectionne le point mémoire en rendant le transistor 102 passant, et on applique une tension entre le noeud 122 et la source 124. Un courant passe dans l'élément résistif, ce qui produit de la chaleur, et la température de l'élément résistif s'élève fortement. Le matériau à changement de phase au contact de l'élément résistif de chauffage 116 fond (pour la programmation) ou recristallise (pour l'effacement).

Un problème est qu'une partie de la chaleur produite n'est pas utilisée pour élever la température de l'élément de chauffage 116 et ainsi faire fondre ou recristalliser le matériau 118, mais est absorbée ou évacuée par les matériaux environnant l'élément de chauffage, notamment par le via conducteur 108, selon les dimensions et les matériaux du via. Il faut alors produire beaucoup de chaleur pour obtenir, dans l'élément de chauffage, une température suffisante pour que le point mémoire soit programmé ou effacé. Il en résulte le problème, évoqué en préambule, de courants de programmation et d'effacement élevés. Le transistor 102 doit être de grande taille pour permettre le passage de ces courants, ce qui pose les problèmes de compacité susmentionnés.

On propose ci-après un point mémoire à courants de programmation et d'effacement réduits, ce point mémoire pouvant alors être particulièrement compact.

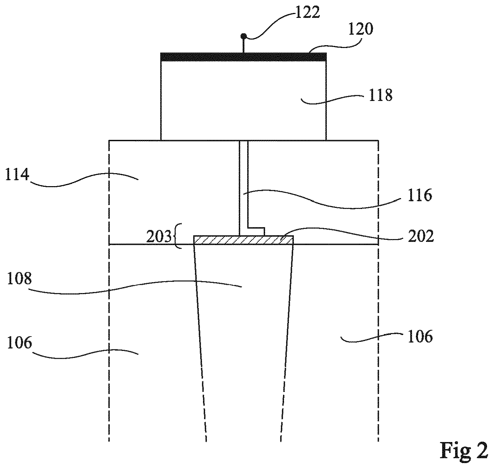

La figure 2 est un exemple n'entrant pas dans le cadre de l'invention revendiquée et est une vue en coupe, partielle et schématique, d'un mode de réalisation d'un point mémoire. Seules les parties supérieures des points mémoire sont représentées en figures 2 et suivantes.

Le point mémoire de la figure 2 reprend les éléments du point mémoire de la figure 1, ou des éléments similaires, agencés de manière identique ou similaire, à la différence qu'une barrière thermique 203 est disposée entre le via 108 et l'élément résistif de chauffage 116, la barrière thermique permettant le passage de courant entre le via et l'élément 116.

La barrière thermique permet de réduire fortement les pertes vers le via 108 de la chaleur produite dans l'élément de chauffage 116. Il suffit alors d'une quantité réduite de chaleur produite pour que la température de l'élément de chauffage 116 s'élève fortement et que le point mémoire soit programmé ou effacé. Les courants de programmation et d'effacement sont donc réduits.

La barrière thermique 203 résulte ici des interfaces entre une couche 202 en un matériau électriquement isolant et les matériaux du via 108 et de l'élément 116.

En effet, de la différence entre le matériau de la couche 202 et les matériaux du via 108 et de l'élément 116 résulte, de chaque côté de la couche 202, une résistance thermique d'interface (en anglais "Interfacial thermal resistance") c'est-à-dire une résistance qui s'oppose au passage de la chaleur entre deux matériaux différents en contact l'un avec l'autre. Cette résistance d'interface apparaît par exemple lorsque les vibrations, ou phonons, des réseaux cristallins des matériaux se propagent différemment dans les deux matériaux, et/ou ont des fréquences différentes dans les deux matériaux. Les phonons ont alors tendance à être réfléchis par l'interface. Les résistances thermiques d'interface ainsi obtenues entre matériaux électriquement isolant et conducteur sont particulièrement élevées, par exemple supérieures à 10⁻⁸ m²·K/W. C'est pourquoi les interfaces de la couche 202 avec les matériaux en contact avec ses deux faces forment une barrière thermique 203 particulièrement efficace. Les courants de programmation et d'effacement sont alors particulièrement réduits.

Le courant électrique, en particulier de programmation et d'effacement, passe du matériau résistif 116 au via 108 par un phénomène de type effet tunnel. Pour cela, on prévoit que la couche 202 soit suffisamment mince. A titre d'exemple, lorsque le matériau de la couche 202 est en nitrure de silicium, ou en oxyde d'aluminium, d'hafnium ou de silicium, la couche 202 a une épaisseur par exemple inférieure à 1 nm. La couche 202 peut aussi être en un matériau semiconducteur non dopé, par exemple du silicium, du germanium, ou du silicium-germanium, cristallin ou amorphe, ou en un matériau ayant une résistivité électrique supérieure à 2,5·10⁻⁵ Ω·m.

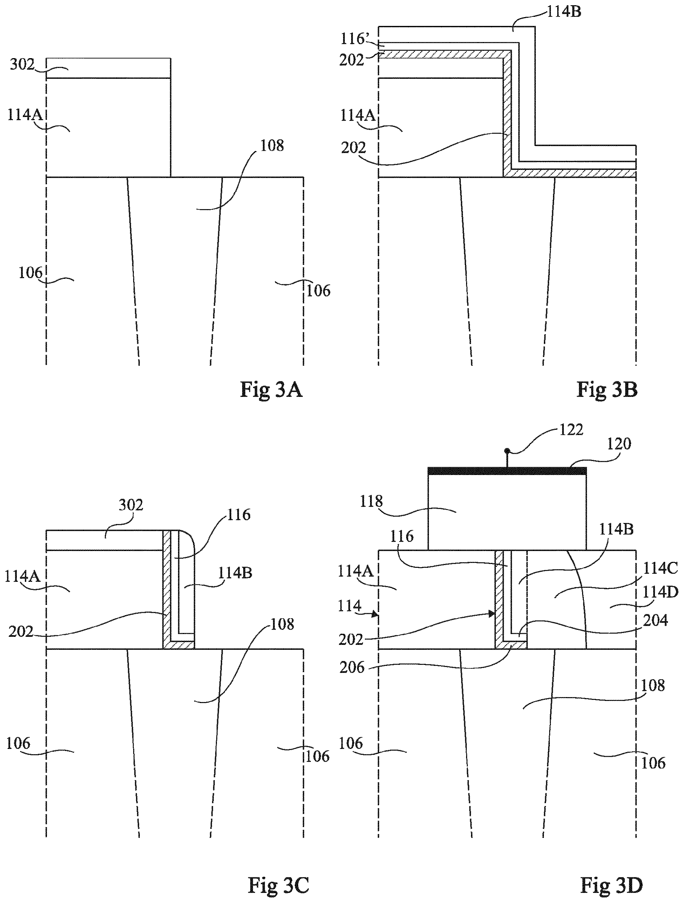

Les figures 3A à 3D sont des exemples n'entrant pas dans le cadre de l'invention revendiquée et sont des vues en coupe, partielles et schématiques, illustrant des étapes successives d'un mode de réalisation d'un procédé de fabrication d'un point mémoire, par exemple du type de celui de la figure 2.

A l'étape de la figure 3A, on a formé dans une couche isolante 106, par exemple en oxyde de silicium, un via 108, par exemple en tungstène, connecté au drain d'un transistor non représenté. Le via 108 affleure la surface supérieure de la couche isolante 106, par exemple suite à un polissage mécanochimique.

On recouvre ensuite la structure d'une couche électriquement isolante 114A, par exemple en nitrure de silicium, puis d'une couche 302, par exemple en oxyde de silicium. La couche 114A est une portion d'une future couche électriquement isolante 114 traversée par un futur élément résistif de chauffage. A titre d'exemple, l'épaisseur de la couche 114 est comprise entre 30 et 150 nm.

On grave ensuite les couches 302 et 114A de sorte que le flanc des portions restantes de ces couches soit situé sur le via 108.

A l'étape de la figure 3B, on forme de manière conforme sur la structure successivement une couche 202, une couche 116', et une couche 114B. La couche 202 correspond à celle de la figure 2 et est destinée à former la future barrière thermique. Le futur élément résistif de chauffage sera formé d'une portion de la couche 116', la couche 116' étant par exemple en nitrure de silicium et de titane. La couche 114B est électriquement isolante, par exemple en nitrure de silicium, et est d'épaisseur par exemple comprise entre 30 et 50 nm.

A l'étape de la figure 3C, on élimine par gravure anisotrope les parties horizontales de la couche 114B. On grave ensuite les parties accessibles des couches 116' et 202.

A l'étape de la figure 3D, on procède successivement au dépôt d'une couche 114C en un matériau électriquement isolant, par exemple en nitrure de silicium. On procède à la gravure des parties horizontales de la couche 114C. Il en résulte une portion de la couche 114C recouvrant la partie restante, verticale, de la couche 114B.

On recouvre ensuite la structure d'une couche 114D électriquement isolante, par exemple en oxyde de silicium, de façon à remplir tout l'espace resté libre sous le niveau supérieur de la couche 114A.

Après cela, on retire tous les éléments de la structure situés au-dessus du niveau supérieur de la couche 114A, par exemple par polissage mécanochimique, puis on forme une région en matériau à changement de phase 118, recouverte d'une prise de contact 120.

On obtient ainsi, dans une couche isolante 114 composée des portions restantes des couches 114A, 114B, 114C et 114D, un élément résistif 116 de chauffage du matériau à changement de phase 118, et une barrière thermique. L'élément résistif 116 obtenu par le procédé décrit ci-dessus comprend un mur vertical et une portion horizontale 204 qui s'étend d'un côté à partir du bas du mur.

La barrière thermique comprend une portion 206 de la couche 202 située entre le via 108 et l'élément de chauffage 116. A partir de la portion 206, la couche 202 se prolonge verticalement, sur l'une des faces du mur, entre le mur et la portion restante de la couche isolante 114A, jusqu'au matériau à changement de phase 118.

De préférence, le matériau de la couche 202 est prévu pour former avec celui de la couche isolante 114A une résistance thermique d'interface élevée, par exemple supérieure à 2·10⁻⁹ m²·K/W. Cette résistance thermique d'interface est située entre la couche 114A et l'élément de chauffage 116. On limite ainsi la fuite vers la couche 114A de la chaleur produite dans l'élément chauffant. Le point mémoire peut alors être programmé ou effacé avec un courant particulièrement réduit.

La résistance thermique d'interface située entre la couche 114A et l'élément de chauffage 116, et la barrière thermique entre le via 108 et l'élément 116, sont obtenues à partir des interfaces d'une même couche 202 avec les matériaux qui l'environnent, et sont ainsi obtenues d'une manière particulièrement simple.

On note que, si le matériau de la couche 202 était électriquement conducteur, par exemple de résistivité électrique supérieure à 2,5.10⁻⁵ Ω·m, une partie du courant circulant dans le point mémoire s'écoulerait du via 108 au matériau 118 en passant par la couche 202 et non par l'élément 116. Cette partie du courant ne serait donc pas utilisée pour le chauffage de l'élément 116, et il en résulterait une augmentation des courants de programmation et d'effacement. Ceci est évité du fait que la couche 202 est en matériau électriquement isolant. La prévision de la couche 202 en un matériau électriquement isolant permet d'obtenir, par les interfaces d'une même couche 202 avec les matériaux qui l'environnent, simultanément la résistance thermique d'interface située entre la couche 114A et l'élément 116, et la barrière thermique entre le via 108 et l'élément de chauffage 116.

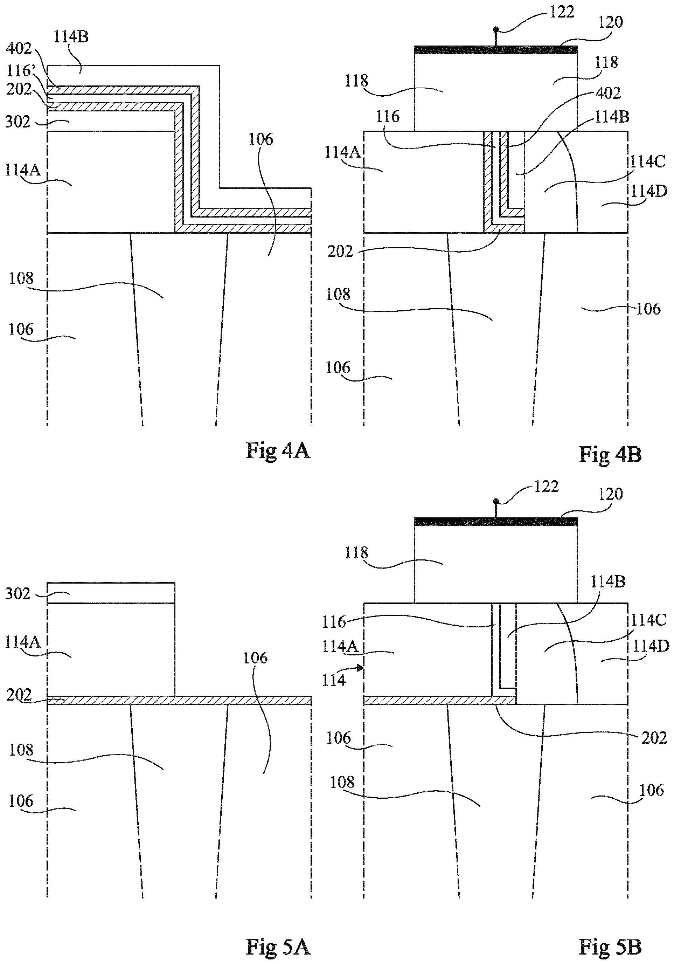

Les figures 4A et 4B sont des exemples n'entrant pas dans le cadre de l'invention revendiquée et sont des vues en coupe, partielles et schématiques, illustrant des étapes d'une variante du procédé des figures 3A à 3D.

L'étape de la figure 4A correspond à celle de la figure 3B, et diffère de l'étape de la figure 3B en ce qu'une couche électriquement isolante 402 est déposée de manière conforme entre les couches 116' (futur élément de chauffage) et 114B (future portion de la couche isolante 114). Le matériau de la couche 402 est choisi pour former, en contact avec celui de la couche 114B, une résistance thermique d'interface élevée, par exemple supérieure à 2·10⁻⁹ m²·K/W. A titre d'exemple, la couche 402 est en oxyde de hafnium, d'aluminium ou de silicium, ou en un semiconducteur non dopé, par exemple amorphe. A titre d'exemple, l'épaisseur de la couche 402 est comprise entre 1 et 5 nm.

L'étape de la figure 4B correspond à celle de la figure 3D, à laquelle on obtient le point mémoire. Une barrière thermique est formée par les interfaces d'une portion de la couche 402 avec la couche 114B. Cette barrière thermique est située entre l'élément de chauffage 116 et la portion verticale restante de la couche 114B.

La prévision de la couche 402 formant une barrière thermique d'interface avec la couche 114B permet de réduire les pertes de chaleur de l'élément chauffant vers la portion restante de la couche 114B. On peut alors programmer ou effacer le point mémoire avec des courants particulièrement réduits.

Les figures 5A et 5B sont des exemples n'entrant pas dans le cadre de l'invention revendiquée et sont des vues en coupe, partielles et schématiques, illustrant des étapes d'un autre mode de réalisation d'un procédé de fabrication d'un point mémoire. Le procédé des figures 5A et 5B diffère de celui des figures 3A à 3D en ce que la couche 202 (futur élément d'une barrière thermique) est formée avant la formation et la gravure des couches 114A et 302.

Ainsi, à l'étape de la figure 5A, après avoir recouvert la couche 106 et le via 108 successivement par des couches 202, 114A et 302, on retire une partie des couches 302 et 114A de sorte que le flanc des portions restantes des couches 114A et 302 soit situé au-dessus du via 108. On grave ensuite les parties accessibles de la couche 202.

A l'étape de la figure 5B, on a formé le reste du point mémoire de la manière décrite précédemment en relation avec les figures 3B à 3D en omettant la couche 202 déjà formée.

Le point mémoire obtenu par le procédé des figures 5A et 5B diffère de celui des figures 3B à 3D en ce que la couche 202 se prolonge sous la couche isolante 114A au lieu de se prolonger sur une face de l'élément de chauffage.

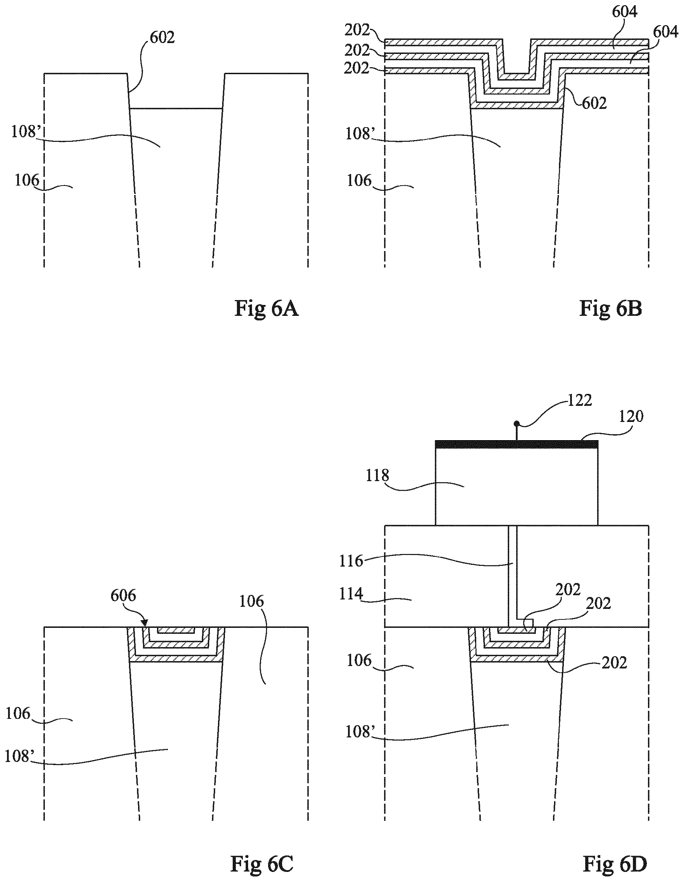

Les figures 6A à 6D sont des modes de réalisation de l'invention et sont des vues en coupe, partielles et schématiques, illustrant des étapes d'un autre mode de réalisation d'un procédé de fabrication d'un point mémoire.

A l'étape de la figure 6A, dans une couche isolante 106, on forme un via 108', par exemple en tungstène, connecté à un transistor non représenté. Le via 108' remplit partiellement un trou 602 traversant la couche 106, et n'atteint pas la surface supérieure de la couche 106. A titre d'exemple, pour obtenir le via 108', on remplit d'abord le trou 602 de tungstène, on procède ensuite à un polissage mécanochimique retirant tous les éléments situés au-dessus de la surface supérieure de la couche 106, puis on grave partiellement, de manière sélective, la partie supérieure du tungstène remplissant le trou. A titre d'exemple, le niveau supérieur du via 108' est 5 à 50 nm en dessous de celui de la surface supérieure de la couche 106.

A l'étape de la figure 6B, on dépose successivement, par exemple de manière conforme, des couches 202 en un matériau électriquement isolant, par exemple en oxyde d'aluminium, alternées avec des couches 604 en un matériau électriquement conducteur, par exemple en tungstène. Chaque couche électriquement isolante est suffisamment mince pour permettre le passage de courant. A titre d'exemple, l'épaisseur de chaque couche 202 est inférieure à 1 nm. A titre d'exemple, l'épaisseur de chaque couche 604 est comprise entre 1 et 5 nm. Trois couches 202 et deux couches 604 intercalées entre les couches 202 sont représentées à titre d'exemple. De préférence, on prévoit entre 2 et 10 couches 202. La couche supérieure est une couche 202 dans l'exemple représenté, mais peut aussi être une des couches 604. L'empilement remplit par exemple entièrement la partie du trou 602 située au-dessus du via.

A l'étape de la figure 6C, on retire les éléments situés au-dessus du niveau de la surface supérieure de la couche 106. Il en résulte une portion 606 de l'empilement des couches 202 située sur le via 108' et en prolongement du via 108'. La portion 606 de l'empilement affleure la surface supérieure de la couche 106.

A l'étape de la figure 6D, on forme le reste du point mémoire, à savoir une couche isolante 114 traversée par un élément chauffant 116, la couche isolante 114 étant surmontée d'un matériau à changement de phase 118 situé sur l'élément chauffant. L'élément chauffant est formé sur la portion 606 de l'empilement.

Dans le point mémoire obtenu, une résistance thermique d'interface est formée par chaque contact entre matériaux des couches 202 et 604. On a ainsi plusieurs barrières thermiques entre le via 108' et l'élément de chauffage. Il en résulte que l'élément de chauffage est particulièrement bien isolé thermiquement du via. Le point mémoire peut ainsi être programmé ou effacé par le passage d'un courant particulièrement réduit.

Des modes de réalisation particuliers ont été décrits. Diverses variantes et modifications apparaîtront à l'homme de l'art. En particulier, bien que la couche 202 de la barrière thermique de la figure 2 soit directement en contact avec le via et avec l'élément de chauffage, des conducteurs électriques peuvent être prévus entre la couche 202 et le via, et/ou entre la couche 202 et l'élément de chauffage, l'essentiel étant que les interfaces de la couche 202 avec les matériaux en contact avec les deux faces de la couche 202 forment une barrière thermique.

Divers modes de réalisation avec diverses variantes ont été décrits ci-dessus. On notera que l'homme de l'art pourra combiner divers éléments de ces divers modes de réalisation et variantes sans faire preuve d'activité inventive. En particulier, on peut prévoir dans le procédé des figures 5A et 5B une couche électriquement isolante 402, similaire à celle de la variante des figures 4A et 4B, entre les couches 116' (correspondant à l'élément de chauffage) et 114B (correspondant à la couche isolante 114). On obtient alors une barrière thermique supplémentaire, similaire à celle formée par la couche 402 de la figure 4B, entre l'élément chauffant et l'isolant 114B.

Dans le procédé des figures 5A et 5B, on peut former, au lieu d'une seule couche 202, plusieurs couches 202 séparées de couches conductrices, par exemple en tungstène. On obtient ainsi plusieurs barrières thermiques entre l'élément de chauffage et le via.

Par ailleurs, on peut mettre en oeuvre les divers modes de réalisation et variantes des procédés des figures 3A à 5B, en remplaçant le via 108 par le via 108' surmonté de la portion 606 de la structure obtenue à l'étape de la figure 6C.

## Revendications

1. Point mémoire à matériau à changement de phase, comprenant, sur un via (108') de liaison avec un transistor (102), un élément de chauffage (116) du matériau à changement de phase (118), **caractérisé par**, entre le via et l'élément de chauffage (116), plusieurs premières couches (202) en un matériau électriquement isolant ou de résistivité électrique supérieure à 2,5·10⁻⁵ Ω.m, et des deuxièmes couches électriquement conductrices (604) intercalées entre les premières couches, les interfaces entre les premières couches et les deuxièmes couches formant des barrières thermiques, les premières couches étant suffisamment minces pour pouvoir être traversées par un courant électrique par un effet de type effet tunnel.

2. Point mémoire selon la revendication 1, dans lequel lesdites premières couches (202) sont d'épaisseur inférieure à 1 nm.

3. Point mémoire selon la revendication 1 ou 2, dans lequel chacune desdites interfaces forme une résistance thermique d'interface supérieure à 10⁻⁸ m²·K/W.

4. Point mémoire selon l'une quelconque des revendications 1 à 3, dans lequel le matériau desdites premières couches (202) est dans le groupe comprenant : le nitrure de silicium ; l'oxyde d'aluminium ; l'oxyde d'hafnium ; l'oxyde de silicium ; le silicium ; le silicium-germanium ; et le germanium.

5. Point mémoire selon l'une quelconque des revendications 1 à 4, dans lequel les deuxièmes couches sont en tungstène et ledit matériau électriquement isolant (202) est de l'oxyde d'aluminium.

6. Procédé de réalisation d'un point mémoire selon l'une quelconque des revendications 1 à 5, comprenant :
a) former le via de liaison (108') ;
b) former sur le via l'élément de chauffage (116) du matériau à changement de phase (118) ; et
c) entre les étapes a) et b), former les premières couches et les deuxièmes couches.

7. Procédé selon la revendication 6, comprenant, entre les étapes a) et b) :
a1) recouvrir la structure d'une couche isolante (114A) ; et
a2) graver ladite couche isolante sur toute son épaisseur en dehors d'une portion de ladite couche isolante, un flanc de ladite portion étant situé sur le via (108 ; 108'),
l'élément de chauffage (116) étant formé sur ledit flanc.

8. Procédé selon la revendication 7, dans lequel l'étape c) a lieu avant l'étape a1).

9. Procédé selon la revendication 7, dans lequel l'étape c) a lieu après l'étape a2).

## Patentansprüche

1. Speicherzelle mit einem Phasenänderungsmaterial, die auf einem Via bzw. einer Durchkontaktierung (108') zur Kontaktierung eines Transistors (102) ein Heizelement (116) zum Heizen des Phasenänderungsmaterial (118) aufweist, **gekennzeichnet durch**, zwischen dem Via und dem Heizelement (116), mehrere erste Schichten (202) aus einem Material, das elektrisch isolierend ist oder einen elektrischen Widerstand von größer 2.5_{*}10⁻⁵ Ω.m ist, und zweite, elektrisch leitende Schichten (604), die zwischen den ersten Schichten angeordnet sind, wobei die Grenzflächen zwischen den ersten Schichten und den zweiten Schichten thermische Barrieren bilden und die ersten Schichten ausreichend dünn sind, um von einem elektrischen Strom aufgrund eines Tunneleffekts durchquert werden zu können.

2. Speicherzelle nach Anspruch 1, wobei die ersten Schichten (202) Dicken von kleiner als 1 nm aufweisen.

3. Speicherzelle nach Anspruch 1 oder 2, wobei jede der Grenzflächen einen thermischen Grenzflächenwiderstand von mehr als 10⁻⁸ m²_{*}K/W bildet.

4. Speicherzelle nach einem der Ansprüche 1 bis 3, wobei das Material der ersten Schichten (202) zu der Gruppe gehört, die Folgendes aufweist: Siliziumnitrid; Aluminiumoxid; Hafniumoxid; Siliziumoxid; Silizium; Silizium-Germanium; und Germanium.

5. Speicherzelle nach einem der Ansprüche 1 bis 4, wobei die zweiten Schichten aus Wolfram und das elektrisch isolierende Material aus Aluminiumoxid hergestellt sind.

6. Verfahren zur Herstellung einer Speicherzelle nach einem der Ansprüche 1 bis 5, aufweisend:
a) Ausbilden eines Vias bzw. einer Durchkontaktierung (108')
b) Ausbilden eines Elements (116) zum Heizen des Phasenwechselmaterials (118) auf dem Via; und
c) zwischen den Schritten a) und b) Ausbilden der ersten Schichten und der zweiten Schichten.

7. Verfahren nach Anspruch 6, aufweisend zwischen den Schritten a) und b)
a1) Bedecken der Struktur mit einer Isolierschicht (114A);
a2) Ätzen der Isolierschicht über ihre gesamte Dicke außerhalb eines Abschnitts der Isolierschicht, wobei eine Seite des Abschnitts auf dem Via (108; 108') angeordnet ist,
wobei das Heizelement (116) auf dieser Seite ausgebildet ist.

8. Verfahren nach Anspruch 7, wobei Schritt c) vor Schritt a1) stattfindet.

9. Verfahren nach Anspruch 7, wobei Schritt c) nach Schritt a2) erfolgt.

## Claims

1. A memory cell comprising a phase-change material comprising, on a via (108') of connection to a transistor (102), an element (116) for heating the phase-change material (118) **characterized by**, between the via and the heating element (116), several first layers (202) made of a material which is electrically insulating or which has an electric resistivity greater than 2.5·10⁻⁵ Ω.m, and second electrically conductive layers (604) interposed between the first layers, the interfaces between the first layers and the second layers forming thermal barriers, the first layers being sufficiently thin to be able to be crossed by an electric current due to a tunnel-type effect.

2. The memory cell of claim 1, wherein said first layers (202) have thicknesses smaller than 1 nm.

3. The memory cell of claim 1 or 2, wherein each of said interfaces forms an interfacial thermal resistor greater than 10⁻⁸ m²·K/W.

4. The memory cell of any of claims 1 to 3, wherein the material of said first layers (202) belongs to the group comprising: silicon nitride; aluminum oxide; hafnium oxide; silicon oxide; silicon; silicon-germanium; and germanium.

5. The memory cell of any of claim 1 to 4, wherein the second layers are made of tungsten and said electrical isolating material is made aluminum oxide.

6. A method of forming a memory cell of any of claims 1 to 5, comprising:
a) forming a via (108')
b) forming on the via an element (116) for heating the phase-change material (118); and
c) between steps a) and b), forming the first layers and the second layers.

7. The method of claim 6, comprising, between steps a) and b) :
a1) covering the structure with an insulating layer (114A);
a2) etching said insulating layer across its entire thickness outside of a portion of said insulating layer, one side of said portion being located on the via (108; 108'),
the heating element (116) being formed on said side.

8. The method of claim 7, wherein step c) takes place before step a1).

9. The method of claim 7, wherein step c) takes place after step a2).
